# EUROPEAN PATENT SPECIFICATION

(11) **EP 0 537 459 B1**
(45) Date of publication and mention of the grant of the patent: **13.12.1995**
(21) Application number: 92114883.9
(22) Date of filing: 01.09.1992
(51) Int. Cl.: H02M 5/257, H03H 7/06, H03K 17/08

(54) **An electric, RF noise-attenuating filter for power supply control devices**
Elektrisches Filter mit Hochfrequenzrauschdämpfung für Stromversorgungsteurgeräte
Filtre électrique d'atténuation de bruit RF pour dispositifs de commande de circuits d'alimentation

(30) Priority: 16.10.1991 IT MI912732
(43) Date of publication of application: 21.04.1993
(73) Proprietor: BTICINO S.P.A., 20122 Milano (IT)
(72) Inventor: Rossetti, Gianpaolo, I-26100 Cremona (IT); De Tomasi, Carlo, I-21100 Varese (IT)
(74) Representative: Maggioni, Claudio

(56) References cited:
- EP-A- 0 279 137
- BE-A- 727 014
- CH-A- 500 580
- FR-A- 2 069 562

## Description

This invention relates to electric filters, particularly to a filter for attenuating radio-frequency noise produced by a device controlling the supply of electric power to a load from a source of alternate current through a controlled conduction, static switch.

From FR-A-2 069 562 is known a filter provided with all the features of the preamble of the claim.

As is known, control devices of the controllable static switch type are extensively utilized with electric appliances for continuously varying the brilliancy of standard or halogen filament lamps, controlling electric fans, or the like. They usually employ semiconductor devices, known as triacs and thyristors, which when connected in series between the power supply and the electric load, operate as switches whose state can be controlled through a specially provided control circuit. The latter operates to close the supply circuit to the electric load at each half-wave of the AC supply according to a predetermined make angle. In this way, the power being transferred to the load can be modulated continuously within a broad range -- in the instance of lamps, between 0% and 100%.

Also known is that the control device produces RF pulses due to the high current peaks which are generated as a triac or thyristor is turned on/off.

To attenuate such pulses which, by dumping through the power mains, could interfere with reception of wireless and TV signals or operation of other electronic apparatus, a filter is customarily connected between the device and the load which comprises essentially a serially-connected induction coil and a shunt-connected capacitor. Steady state noise attenuation should conform with relevant standards and recommendations issued by the agencies appointed to regulate the civil uses of electric and electronic apparatus.

In dimensioning the filter, due consideration should also be given to possible overloading of the static switch as the load is turned on. Accordingly, with inductive loads such as transformers or motors, the filter coil should have lower inductance than that required by resistive loads, such as filament lamps, because the effects of the load inductance add to the effects of the filter inductance. Of course, this is true both as regards the attenuation of RF pulses and as regards the generation of overcurrents upon the load being turned on. In other words, if a high inductance filter suiting a resistive load were used with an inductive load, as the load is turned on, there would be a risk of harming the static switch due to the high current transients from the filter inductance adding to that of the load. To obviate this, the prior art has provided two types of control devices: the one equipped with a filter for resistive loads, and the other equipped with a filter for inductive loads.

It may be appreciated that this situation creates some problems both for the manufacturer of the devices, in that two discrete product lines must be made available thereby, and the user who, to obtain the appropriate control device, has to know beforehand whether the load to be controlled is a resistive or inductive type.

Another known approach has proposed to use bipolar or field-effect, power transistors as static switches, to be controlled from circuits capable of turning the transistor on and off gradually to prevent the appearance of RF noise, thereby doing away with the use of a filter. While that approach is a convenient one from the engineering standpoint, its acceptance has been restricted mainly by the high cost of power transistors compared to triacs and thyristors, less expensive.

It is the object of this invention to obviate the drawbacks mentioned hereinabove by providing a filter for a device controlling the power being supplied to a load through a conventional static switch, which can be used equally well with resistive and inductive loads, and is simple and economical to manufacture.

This object is achieved according to the invention by a filter as defined and characterized in the claim appended to this specification.

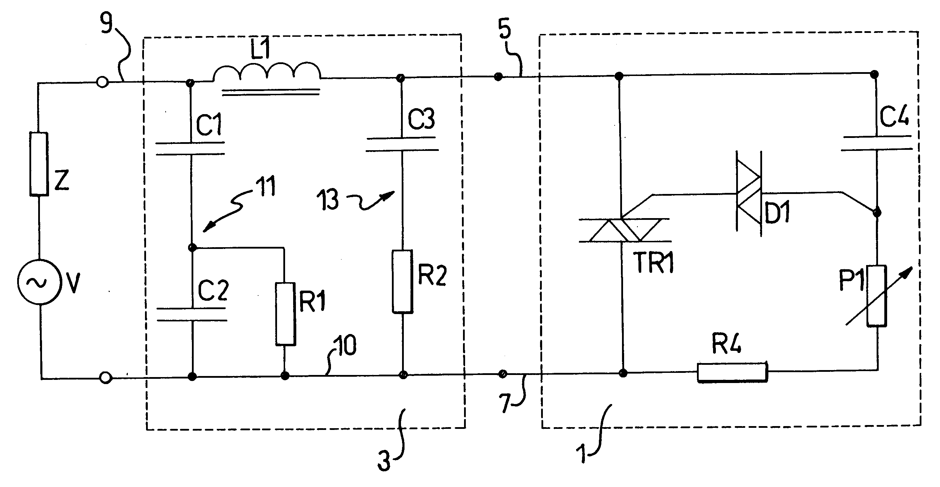

The invention will be more clearly understood from the following detailed description of an exemplary and in no way limitative embodiment thereof, to be taken in conjunction with the accompanying drawing, the single Figure whereof shows a circuit diagram of a control device incorporating a filter according to the invention.

With reference to the drawing, denoted by Z is a resistive or inductive load to be powered from an AC source V, indicated at 1 is a power control block constituting the supply control device, and indicated at 3 is a filter block connected between the control device 1 and the serial connection of the load Z and the source V.

The control device, being a common type, comprises a two-way controllable conduction, static switch (triac) TR1, connected between the input terminals 5 and 7 of block 1, and a two-way diode (diac) D1 connected between the control terminal of the triac TR1 and the junction point of a capacitor C4 to a potentiometer P1. The last-mentioned two elements are connected in series together and to a resistor R4, between the input terminals 5 and 7 of block 1.

The filter 3 consists of an induction coil L1, having preferably a toroidal core, which is connected serially between the terminal 5 of block 1 and a terminal 9 of the filter which is connected to the load Z, and a cross leg 11 connected between the terminal 9 and a terminal 10 of the filter which is connected to the terminal 7 of the adjust block. The leg 11 comprises two series capacitors C1 and C2 and a resistor R1 in parallel with capacitor C2. In accordance with the invention, provided between the terminal of the inductor L1 connected to the terminal 5 of the control device 1 and the terminal 10 is a cross leg 13 comprising a capacitor C3 in series with a resistor R2.

In operation, during a supply half-wave, upon the voltage across the capacitor C4, which is charged through the resistor R4 and the potentiometer P1, attaining a value whereat the diac D1 enters conduction, the triac will go conductive and pass a current to the load. By adjustment of the potentiometer P1 setting, the charge rate of the capacitor C4 can be adjusted, and with it, the conduction time of triac TR1. The RF pulses generated by the triac 1 during its switching cycle are attenuated by the filter 3 through the combined effects of the (high) series impedance of coil L1 and the (low) shunt impedance of the capacitive leg 11. It should be noted that the resistor R1, in parallel with the capacitor C2, is effective to lower the overall capacitance across the leg 11 as regards the transients present on the power mains. The inductance of the coil L1 and capacitances of the capacitors C1 and C2 are selected, when the load Z is regarded as a purely resistive one, such that RF noise detectable between the terminals 9 and 10 of the filter will be at a lower level than the highest allowable level, and that the current transients from the inductance of coil L1 as the load is turned on will not exceed the limits set by the specifications of triac TR1.

This being the situation, should the leg 13 be omitted from the filter of this invention, the combination of the control device 1 and the filter 3 could only be used with a basically resistive load. In fact, if the load Z had a high inductive component, this would add to the inductance of the coil L1, thereby the current transients as the load is turned on could reach or exceed the allowable limits for triac TR1.

By contrast, this is effectively prevented by the filter of this invention by means of the leg 13 provided on condition, of course, that the components C3 and R2 have been suitably dimensioned. Specifically, the capacitance of C3 and resistance of R2 should be selected such that the impedance of the leg 13 is very high to the AC supply, but at the same time very low to the current transients due to any inductances which might appear in series with the circuit as the load is turned on. It is necessary, moreover, that the components of the leg 13 be dimensioned to avoid resonant conditions of the filter which could impede its ability to attenuate RF noise. Based on these dimensional conditions, which are part of the characteristic aspects of the invention, the values of the inventive filter components can be computed using conventional network design techniques.

In a preferred embodiment wherein the coil L1 had an inductance of 2.2 mH and the leg 11 a capacitance of about 300 nF, the capacitor C3 had a capacitance of 220 nF and the resistor R2 a resistance of 470 Ohms.

As may be seen, the filter of this invention fully achieves its object. It can be used, in fact, equally well with resistive and inductive loads, and is quite simple and economical since it requires but two additional components of low cost.

## Claims

1. A filter for attenuating radio-frequency noise produced by a device (1) controlling the supply of electric power to a load (Z) from a source of alternate current (V) through a controlled conduction, static switch (TR1) connected in series with the load, said filter (3) comprising an inductor (L1) which has a first terminal (9) connected to the load (Z) and a second terminal connected to one of the static switch (TR1) terminals (5), and a capacitor (C1,C2) connected between the first terminal (9) of the inductor (L1) and the other terminal (7) of the static switch (TR1), said filter further comprising a leg (13), connected in parallel with the static switch (TR1) and comprising a capacitive means (C3) and resistive means (R2) connected serially to each other, said filter being characterized in that it is dimensioned such that the leg (13) has very high impedance to the alternate current supply and a very low impedance to the transient current peaks generated as the load (Z) is turned on, and such as to create no RF resonant conditions.

## Patentansprüche

1. Filter zur Dämpfung von Hochfrequenzrauschen, das von einem Bauteil (1) verursacht wird, welches die Zuführung elektrischer Leistung von einer Wechselspannungsquelle (V) zu einer Last (Z) über ein mit der Last in Reihe geschaltetes, statisches Schaltelement (TR1) mit gesteuertem Stromdurchlaß steuert, wobei das Filter (3) eine Drosselspule (L1), die mit einem ersten Anschluß (9) an die Last (Z) und mit einem zweiten Anschluß an einen (5) der Anschlüsse des statischen Schaltelements (TR1) angeschlossen ist, und einen zwischen den ersten Anschluß (9) der Drosselspule (L1) und den anderen Anschluß (7) des statischen Schaltelements (TR1) eingeschleiften Kondensator (C1, C2) sowie ferner einen Zweig (13) enthält, der parallel zu dem statischen Schaltelement (TR1) geschaltet ist und in Reihe zueinander geschaltet eine Kapazität (C3) und einen Widerstand (R2) besitzt, wobei das Filter dadurch gekennzeichnet ist, daß es derart ausgelegt ist, daß der Zweig (13) eine sehr hohe Impedanz für die Wechselstromversorgung und eine sehr geringe Impedanz für die beim Anschalten der Last (Z) erzeugten transienten Stromspitzen besitzt und daß keine Hochfrequenzresonanzbedingungen erzeugt werden.

## Revendications

1. Filtre pour atténuer un bruit radiofréquence produit par un dispositif (1) commandant l'alimentation en énergie électrique d'une charge (Z) par une source de courant alternatif (V) par l'intermédiaire d'un commutateur (TR1) statique à conduction commandée, connecté en série avec la charge, ledit filtre (3) comprenant une inductance (L1) dont une première borne (9) est connectée à la charge (Z) et une seconde borne est connectée à l'une des bornes (5) du commutateur (TR1) statique, et un condensateur (C1, C2) connecté entre la première borne (9) de l'inductance (L1) et l'autre borne (7) du commutateur (TR1) statique, ledit filtre comprenant en outre une branche (13), connectée en parallèle avec le commutateur (TR1) statique et comprenant un moyen (C3) capacitif et un moyen (R2) résistif connectés en série l'un à l'autre, ledit filtre étant caractérisé en ce qu'il est dimensionné de telle façon que la branche (13) ait une impédance très élevée vis-à-vis de l'alimentation en courant alternatif et une impédance très faible vis-à-vis des pics de courant transitoires générés lorsque la charge (Z) est mise sous tension, et qu'il ne crée pas de conditions de résonance RF.
